# EUROPEAN PATENT APPLICATION

(11) **EP 4 506 986 A1**
(43) Date of publication of application: **12.02.2025**
(21) Application number: 23191101.7
(22) Date of filing: 11.08.2023
(51) Int. Cl.: H01L 21/687

(54) **WAFER CHUCK, WAFER PROBER AND METHOD FOR COOLING A WAFER**

(71) Applicant: Bluefors Oy, 00370 Helsinki (FI)
(72) Inventor: JÄRVINEN, Jarno, 00370 Helsinki (FI); ROSCHIER, Leif, 00370 Helsinki (FI)
(74) Representative: Berggren Oy

(57) **Abstract**

The present invention relates to a wafer chuck (100) that comprises a plate (101) for holding a wafer (200) and clamping means (102, 106, 107, 109, 110, 112) for clamping the wafer (200) against the plate (101). The clamping means (102, 106, 107, 109, 110, 112) comprises a plurality of claws (102) having first fingers (104), each claw (102) being arranged in connection with the plate (101) so that the wafer (200) can be clamped between the plate (101) and the first finger (104) of the claw (102) and moving means (106, 107, 109, 110, 112) for moving the plurality of claws (102) with respect to the plate (101). The invention also relates to a wafer prober (300) and a method for cooling a wafer (200).

## Description

### TECHNICAL FIELD OF THE INVENTION

The present invention relates to a wafer chuck and a method for cooling a wafer according to the preambles of the appended independent claims. The invention also relates to a wafer prober.

### BACKGROUND OF THE INVENTION

Testing of wafers at very low temperatures has become more common during the last few years. For the testing, a wafer is mounted on a chuck that is cooled with a cooling device to a desired temperature. Thermal contact of the wafer with the chuck is practically always through mechanical pressure contact. Since the mechanical pressure contact between the wafer and the chuck is rather weak, the wafer is not cooled efficiently. Thermal contact could be improved by compressing the wafer more strongly against the chuck. This, however, would create problems with the known chucks due to different thermal contraction of the wafer and the chuck, and as a result the wafer could break during the cooling if the compression locks the wafer too strongly against the chuck.

### OBJECTIVES OF THE INVENTION

It is the main objective of the present invention to reduce or even eliminate the prior art problems presented above.

It is an objective of the present invention to provide a wafer chuck and a method for cooling a wafer. In more detail, it is an objective of the invention to provide a wafer chuck and a method enabling to efficiently cool a wafer to a very low temperature. It is a further objective of the present invention to provide a wafer chuck and a method enabling to cool a wafer without breaking the wafer during the cooling process. It is yet a further objective of the invention to provide a wafer chuck enabling to achieve a very good thermal contact between a wafer and a plate of the wafer chuck.

It is also an objective of the present invention to provide a wafer prober enabling to test wafers at very low temperatures.

In order to realise the above-mentioned objectives, the wafer chuck and the method according to the invention are characterised by what is presented in the characterising portions of the appended independent claims. Advantageous embodiments of the invention are described in the dependent claims.

### DESCRIPTION OF THE INVENTION

A wafer chuck according to the invention comprises a plate for holding a wafer, and clamping means for clamping the wafer against the plate. In the wafer chuck according to the invention, the clamping means comprises a plurality of claws having first fingers, each claw being arranged in connection with the plate so that the wafer can be clamped between the plate and the first finger of the claw, and moving means for moving the plurality of claws with respect to the plate.

A wafer chuck according to the invention can be used in a wafer prober to hold a wafer during testing. By a wafer is meant a (semiconductor) wafer that contains integrated circuits. By a wafer prober is meant a testing device that can electrically test the integrated circuits on the wafer.

The plate of the wafer chuck can receive and hold a wafer on its top side. Preferably, the plate is circular, and it has a diameter corresponding essentially to that of the wafer. The diameter of the plate can be, for example, 200-450 mm, or 200 mm, 300 mm, or 450 mm, and the thickness of the plate can be, for example, more than 5 mm, or 5-15 mm. The plate is made of a heat conductive material, such as copper or gold, to facilitate the rapid transfer of heat away from the wafer. The plate can be made of gold-plated copper.

In the wafer chuck according to the invention, the wafer is meant to be clamped between the plate and the first fingers of the plurality of claws. The claws are arranged in connection with an outer edge of the plate. A first side of the wafer is meant to be arranged against the top side of the plate and the first fingers of the claws are meant to be arranged against a second side of the wafer. The first fingers of the claws are preferably arranged parallel to the plate. The length of the first fingers can be, for example, 5-20 mm, and the width of the first fingers can be, for example, 10-20 mm. Preferably, the wafer chuck comprises at least three claws. The claws can be made of, for example, copper, beryllium copper, brass, aluminium, or stainless steel.

The moving means are attached to the plurality of claws. The moving means are arranged to move the claws in opposite directions between an open position and a closed position so that the wafer can be clamped to and released from the plate. Preferably, the moving means are arranged to move the claws perpendicularly with respect to the plate. The moving means can be arranged to move the claws individually or collectively, and they can be provided with control means for controlling the clamping force. The clamping force can be controlled based on the current temperature, for example, based on the temperature of the plate or the wafer. The moving means can be actuated from outside of a wafer prober. The moving means can be mounted to the plate, or to a supporting structure of the plate, or to other element that is immovable with respect to the plate.

The wafer chuck may comprise a cooling unit that is thermally connected to the plate. In this text, the expression "thermally connected" means that two members are connected via materials having high thermal conductivity. In cryogenic technology, a high thermal conductivity may be, for example, at least 100 W/mK at or above 10 K, at least 10 W/mK at 1 K, at least 1 W/mK at 0.1 K, or at least 0.1 W/mK at 0.01 K. The cooling unit can be thermally connected to a bottom side of the plate with one or more thermal links, such as a cable or bar made of copper or aluminium. The cooling unit is configured to cool the plate to a very low temperature, preferably below 1 K, and more preferably below 100 mK. Because the wafer chuck provides a very good thermal contact between the wafer and the plate, the wafer can thus be cooled efficiently.

An advantage of the wafer chuck according to the invention is that it enables to achieve a very good thermal contact between the wafer and the plate and thus it enables the wafer to be cooled efficiently through the plate. Another advantage of the wafer chuck according to the invention is that it enables to cool a wafer to a very low temperature. Yet another advantage of the wafer chuck according to the invention is that it enables to cool a wafer without breaking the wafer during the cooling process.

According to an embodiment of the invention the plurality of claws have second fingers. The second fingers are arranged to face the bottom side of the plate. The claws having both first and second fingers are essentially C-shaped parts. The distance between the first and second fingers can be, for example, 10-20 mm. The second fingers are preferably arranged parallel to the plate. The length of the second fingers can be, for example, 5-20 mm, and the width of the second fingers can be, for example, 10-20 mm. The moving means can be attached to the second fingers of the claws.

According to an embodiment of the invention the moving means comprises a plurality of actuators, each actuator being attached to one of the plurality of claws. The actuators can be attached to base portions or the second fingers of the claws. The actuators can be arranged to provide a displacement of 1-3 mm, or 1.5-2.5 mm for the claws. The actuators can be mounted to the plate, or to a supporting structure of the plate, or to other element that is immovable with respect to the plate. Depending on the application, the actuators can be linear or rotary actuators. Preferably, the actuators are piezoelectric actuators. By a piezoelectric actuator is meant an actuator that converts electrical energy into a mechanical displacement based on a piezoelectric effect.

According to an embodiment of the invention the moving means comprises a plurality of threaded elements having first and second ends, each threaded element being arranged to go through the second finger of one of the plurality of claws, and a plurality of actuators for rotating the plurality of threaded elements, each actuator being attached to the first end of one of the plurality of threaded elements.

The second fingers of the claws are provided with threaded through-holes through which the threaded elements are arranged to go through. When the threaded element is rotated with the actuator in a first direction of rotation, the first finger of the claw moves towards the plate, and as a result the wafer that is placed on the plate is clamped between the plate and the first finger of the claw. When the threaded element is rotated with the actuator in a second direction of rotation (opposite to the first direction of rotation), the first finger of the claw moves away from the plate, and as a result the wafer is released. The second ends of the threaded elements can be arranged in contact with the bottom side of the plate. In this case, the second ends of the threaded elements are preferably rounded to reduce the friction.

The threaded elements can be, for example, threaded round rods or bolts. The threaded elements can be made of, for example, beryllium copper, brass, aluminium, or stainless steel. The length of the threaded elements can be, for example, 10-20 mm, or 15 mm, and the diameter of the threaded elements can be, for example, 3-7 mm, or 5 mm. The actuators can be arranged to provide a displacement of 1-3 mm, or 1.5-2.5 mm for the claws. The actuators are preferably piezoelectric actuators. The actuators can be mounted to the plate, or to a supporting structure of the plate, or to other element that is immovable with respect to the plate.

According to an embodiment of the invention the moving means comprises a plurality of pivot arms having first and second ends, each pivot arm being rotatable about a pivot point and arranged so that the first end of the pivot arm is located between the plate and the second finger of one of the plurality of claws.

When the pivot arm is rotated about the pivot point in a first direction of rotation, the first end of the pivot arm pushes the second finger of the claw away from the plate, whereby the first finger of the claw moves towards the plate, and as a result the wafer that is placed on the plate is clamped between the plate and the first finger of the claw. When the pivot arm is rotated about the pivot point in a second direction of rotation (opposite to the first direction of rotation), the wafer can be released.

The pivot points are preferably located at or near the first ends of the pivot arms. The length of the pivot arms can be, for example, 30-70 mm, or 50 mm. The pivot arms can be made of, for example, copper, beryllium copper, brass, aluminium, or stainless steel.

According to an embodiment of the invention the moving means comprises a plurality of actuators for rotating the plurality of pivot arms about the pivot points, each actuator being attached to the second end of one of the plurality of pivot arms. The actuators can be arranged to provide a displacement of 1-3 mm, or 1.5-2.5 mm for the claws. The actuators are preferably piezoelectric actuators. The actuators can be mounted to the plate, or to a supporting structure of the plate, or to other element that is immovable with respect to the plate.

According to an embodiment of the invention the moving means comprises a plurality of springs, each spring being attached to the second end of one of the plurality of pivot arms. The springs can be mounted to the plate, or to a supporting structure of the plate, or to other element that is immovable with respect to the plate. The spring is preferably arranged in such a manner that it produces a force to rotate the pivot arm about the pivot point in the first direction of rotation. Preferably, the spring is arranged to produce a force that keeps the wafer that is placed on the plate clamped between the plate and the first finger of the claw. In order to release the wafer, a counterforce is needed to rotate the pivot arm about the pivot point in the second direction of rotation. Such counterforce can be produced, for example, by a wafer loading device during loading of a wafer to the wafer chuck. The springs can be made of, for example, stainless steel, beryllium copper, bronze, or phosphorus bronze.

According to an embodiment of the invention the plurality of actuators are piezoelectric actuators. Depending on the application, the piezoelectric actuators can be linear or rotary piezoelectric actuators.

According to an embodiment of the invention the total clamping force of the clamping means is 200-1200 N. The total clamping force depends on the number of claws as well as the torque of the actuators. The total clamping force is preferably at least 500 N, and more preferably at least 1000 N.

According to an embodiment of the invention the plurality of claws are evenly distributed around the perimeter of the plate. An advantage of the evenly distributed claws is that they provide an essentially uniform distribution of the clamping force on the wafer.

According to an embodiment of the invention the number of claws is 3-6. The number of claws can be 3, 4, 5, or 6.

The present invention also relates to a wafer prober. The wafer prober according to the invention comprises a wafer chuck according to the invention and a cooling unit thermally connected to a plate of the wafer chuck.

The wafer prober according to the invention is a testing device that is used for electrically testing integrated circuits on a wafer. The wafer to be tested is mounted on the plate of the wafer chuck, which can be cooled with the cooling unit. As the plate is cooled, heat from the wafer transfers to the plate by conduction. Because the wafer chuck provides a very good thermal contact between the wafer and the plate, the cooling unit enables to efficiently cool the wafer through the plate of the wafer chuck. Heat is transferred away from the plate through one or more thermal links which are connected between the plate and the cooling unit. The thermal link can be, for example, a cable or bar made of copper or aluminium. The cooling unit is configured to cool the plate to a very low temperature, preferably below 1 K, and more preferably below 100 mK.

The wafer prober comprises a probe card for electrically contacting the integrated circuits on the wafer. The probe card may comprise a printed circuit board (PCB) and one or more contact elements, which can be arranged in electrical contact with contact pads of the integrated circuits. The probe card can be, for example, a needle, vertical pin, or MEMS (Micro Electro-Mechanical System) type probe card depending on the shape and form of the contact elements. The contact elements of the probe card can, for example, be made of tungsten or a tungsten/rhenium alloy. The contact pads of the integrated circuits can, for example, be made of aluminium, copper, copper alloys or many types of solders such as lead-tin and tin-silver. Typically, the probe card is custom-built for each type of wafer so that every integrated circuit on the wafer can be electrically tested.

The probe card is electrically connected to an electronic testing unit that can electrically test the integrated circuits according to a test program. The test program defines the contents of test patterns and the sequence by which they are applied to the integrated circuits. For electrical testing, the probe card is held in place while the wafer mounted on the wafer chuck is moved between testing positions. In each testing position, contact elements of the probe card are arranged in electrical contact with contact pads of a set of integrated circuits, which are then electrically tested with the electronic testing unit.

The wafer prober comprises a vacuum chamber, which allows the integrated circuits to be tested in a controlled environment. The conditions such as the pressure and temperature inside the vacuum chamber can be controlled using various devices. The wafer prober may comprise, for example, a vacuum pump attached to the vacuum chamber for controlling the pressure and a cooling unit attached to the vacuum chamber for controlling the temperature inside the vacuum chamber. When testing the integrated circuits, the pressure inside the vacuum chamber is typically less than 10E-4 mbar. The vacuum chamber can, for example, be made of stainless steel or aluminium.

The wafer prober comprises a first (thermal) radiation shield that is arranged inside the vacuum chamber to enclose the wafer chuck and the probe card. The first radiation shield acts as a thermal shield, reducing the heat transfer. The first radiation shield can be mechanically attached with thermally isolating supports like thin-walled stainless steel tubes to the vacuum chamber or to another radiation shield that encloses the first radiation shield. The first radiation shield can, for example, be made of copper or aluminium.

The first radiation shield is thermally connected to the cooling unit. The cooling unit is used for cooling the interior of the first radiation shield to a desired testing temperature and for maintaining the testing temperature during testing of the integrated circuits. The cooling unit is preferably configured to cool the first radiation shield to a temperature below 2 K, and more preferably below 500 mK. The heat is transferred away from the first radiation shield through one or more thermal links connected between the cooling unit and the first radiation shield. The thermal link can be, for example, a cable or bar made of copper or aluminium.

The wafer prober may comprise further radiation shields, such as a second radiation shield and possibly a third radiation shield. The first radiation shield is arranged inside the second radiation shield, and the second radiation shield is arranged inside the third radiation shield, if a third radiation shield is provided. The second and third radiation shield may be cooled using a mechanical cooler, such as a pulse tube cooler. The second radiation shield may be cooled to a temperature of about 4 K and the third radiation shield may be cooled to a temperature of about 50 K.

The wafer prober may comprise a wafer loading assembly for loading the wafer onto the plate of the wafer chuck. The wafer loading assembly may comprise a loading chamber attached to the vacuum chamber in connection with a gate valve, a loading arm comprising an end defector for carrying the wafer, and an actuator for moving the end defector between the loading chamber and the wafer chuck. A wafer can be loaded onto the wafer chuck as follows. First, the wafer is placed onto the end defector that is located inside the loading chamber. The gate valve is kept closed until the wafer placement has been completed and the desired conditions inside the loading chamber have been achieved. Next, the gate valve is opened, and the end defector is moved inside the vacuum chamber and further through a hatch inside the first radiation shield. Finally, the wafer is transferred from the end defector onto the plate of the wafer chuck and then the end defector is moved back into the loading chamber and the gate valve is closed.

An advantage of the wafer prober according to the invention is that it enables to test integrated circuits on wafers at very low temperatures, below 1 K and even below 100 mK. Another advantage of the wafer prober according to the invention is that it enables to efficiently cool wafers to a desired testing temperature.

According to an embodiment of the invention the cooling unit is a dry cryostat using a closed loop helium circulation. Advantageously, the cooling unit is a dilution refrigerator having a mechanical cooler for pre-cooling. Preferably, the mechanical cooler provides also cooling for the second and third radiation shields. When the dry cryostat is used, the vacuum chamber is kept at room temperature (not in a liquid nitrogen or liquid helium bath) and all the low temperature components are located inside the vacuum chamber. An advantage of the dry cryostat is that the space in which integrated circuits are tested, i.e. the interior of the radiation shield, can be cooled to a temperature below 1 K without immersing the whole system into a liquid helium bath.

The present invention also relates to a method for cooling a wafer. The method according to the invention comprises placing the wafer on a plate of a wafer chuck according to the invention, cooling the plate, determining the temperature of the plate, and after the temperature of the plate has dropped below a predetermined temperature value, clamping the wafer against the plate with a plurality of claws of the wafer chuck.

In the method according to the invention the cooling of the wafer is done in two phases. In the first phase, the wafer is cooled without the wafer being clamped against the plate. In the second phase, the wafer is cooled when the wafer is clamped against the plate. The clamping of the wafer is done after the temperature of the plate has dropped below the predetermined temperature value.

The temperature of the plate can be determined directly by measuring the temperature of the plate, or indirectly by estimating the temperature of the plate based on the time the wafer has been on the plate. The estimation can be based on tabulated values from calibration measurements, or functions fitted to values obtained in calibration measurements.

An advantage of the method according to the invention is that a wafer can be efficiently cooled to a very low temperature without breaking the wafer during the cooling.

According to an embodiment of the invention the predetermined temperature value is in the range of 40-60 K. The predetermined temperature value is preferably in the range of 45-55 K, and more preferably 50 K.

The present invention also relates to a carry-on wafer. A wafer can be attached on the carry-on wafer that improves thermal conductivity radially along the wafer. The wafer can, for example, be glued on top of the carry-on wafer with varnish. The carry-on wafer can have the same or larger size than the wafer. The carry-on wafer is preferably made of the same material than the wafer, whereby thermal contraction does not create any problems. The carry-on wafer and its connection to the wafer can be specifically fabricated to enhance heat transfer, for example, by suitable doping of the carry-on wafer. The heat from the wafer is transferred to the carry-on wafer and then distributed efficiently inside the carry-on wafer. The thermal contact of the carry-on wafer to the wafer chuck can be enhanced with metallization.

The exemplary embodiments of the invention presented in this text are not interpreted to pose limitations to the applicability of the appended claims. The verb "to comprise" is used in this text as an open limitation that does not exclude the existence of also unrecited features. The features recited in the dependent claims are mutually freely combinable unless otherwise explicitly stated.

### BRIEF DESCRIPTION OF THE DRAWINGS

- Fig. 1: illustrates a schematic view of a wafer chuck according to a first embodiment of the invention,
- fig. 2: illustrates a cross-sectional view of the wafer chuck according to fig. 1,
- fig. 3: illustrates a cross-sectional view of a wafer chuck according to a second embodiment of the invention,
- fig. 4: illustrates a cross-sectional view of a wafer chuck according to a third embodiment of the invention,
- fig. 5: illustrates a cross-sectional view of a wafer chuck according to a fourth embodiment of the invention, and
- fig. 6: illustrates a cross-sectional view of a wafer prober according to an embodiment of the invention.

### DETAILED DESCRIPTION OF THE DRAWINGS

The same reference signs are used of the same or like components in different embodiments.

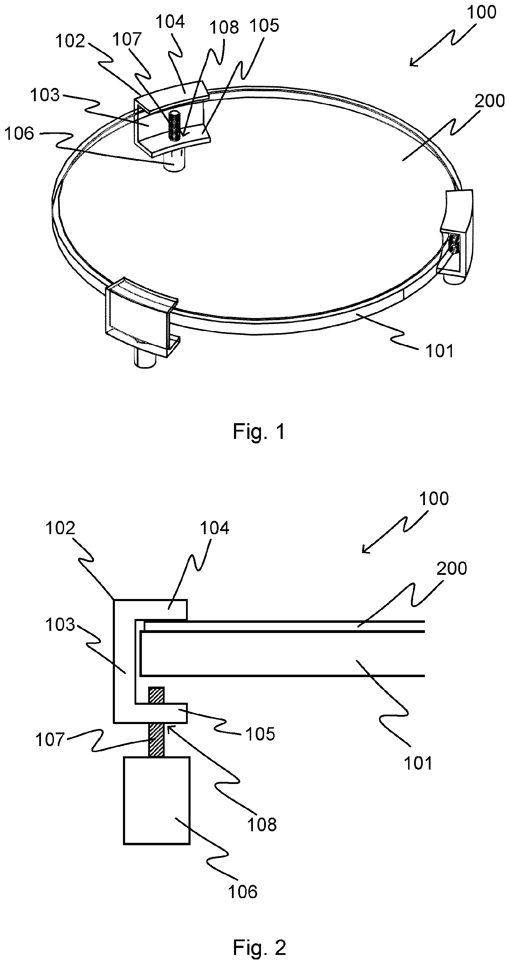

Fig. 1 illustrates a schematic view of a wafer chuck according to a first embodiment of the invention. In fig. 1, the wafer chuck is shown partly transparent. A cross-sectional view of the wafer chuck of fig. 1 is shown in fig. 2.

The wafer chuck 100 comprises a plate 101 for holding a wafer 200 on its top side. The plate 101 is circular, and it has a diameter that corresponds essentially to that of the wafer 200. The plate 101 is made of a heat conductive material to facilitate the rapid transfer of heat away from the wafer 200.

The wafer chuck 100 comprises three claws 102 for clamping the wafer 200 against the plate 101. The claws 102 are evenly arranged around the plate 101 so that the claws 102 can provide an essentially uniform distribution of the clamping force on the wafer 200. Each claw 102 is an essentially C-shaped part that consists of a base portion 103 and two fingers 104 and 105. The fingers 104 and 105 are arranged parallel to the plate 101. The claws 102 are arranged in connection with the plate 101 so that the wafer 200 can be clamped between the fingers 104 and the plate 101. The fingers 105 are facing a bottom side of the plate 101.

The wafer chuck 100 comprises three piezoelectric actuators 106 for moving the claws 102 in opposite directions between an open position and a closed position so that the wafer 200 can be clamped to and released from the plate 101. The piezoelectric actuators 106 are arranged to move the claws 102 perpendicularly with respect to the plate 101. Each piezoelectric actuator 106 is connected to the claw 102 via a threaded rod 107 that is arranged to go through a threaded through-hole 108 in the finger 105. When the threaded rod 107 is rotated with the piezoelectric actuator 106 in a first direction of rotation, the finger 104 moves towards the plate 101, and as a result the wafer 200 that is placed on the plate 101 is clamped between the plate 101 and the finger 104. When the threaded rod 107 is rotated with the piezoelectric actuator 106 in a second direction of rotation, the finger 104 moves away from the plate 101, and as a result the wafer 200 is released.

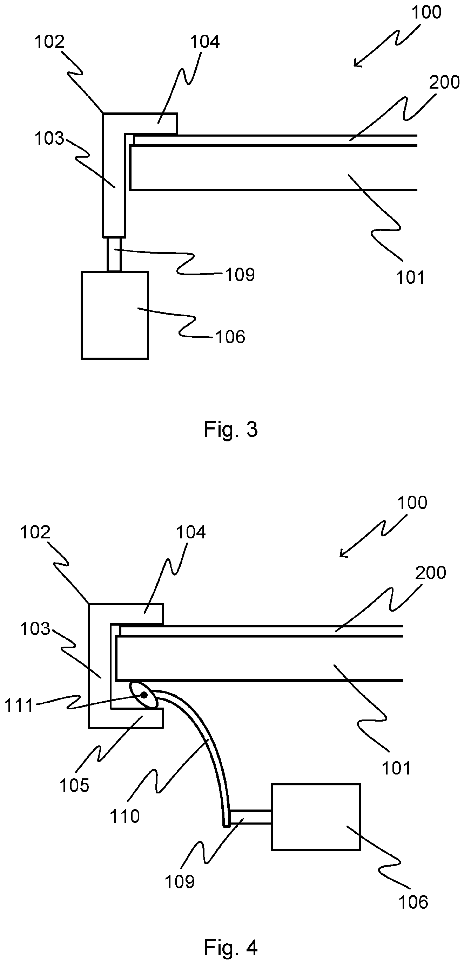

Fig. 3 illustrates a cross-sectional view of a wafer chuck according to a second embodiment of the invention. The wafer chuck 100 comprises a plate 101 for holding a wafer 200 on its top side, and claws 102 (only one can be seen in fig. 3) for clamping the wafer 200 against the plate 101. The claw 102 consists of a base portion 103 and a finger 104. The finger 104 is arranged parallel to the plate 101. The claw 102 is arranged in connection with the plate 101 so that the wafer 200 can be clamped between the finger 104 and the plate 101. A piezoelectric actuator 106 is attached with a rod 109 to the base portion 103. The piezoelectric actuator 106 is used for moving the claw 102 in opposite directions between an open position and a closed position so that the wafer 200 can be clamped to and released from the plate 101. The piezoelectric actuator 106 is arranged to move the claw 102 perpendicularly with respect to the plate 101.

Fig. 4 illustrates a cross-sectional view of a wafer chuck according to a third embodiment of the invention. The wafer chuck 100 comprises a plate 101 for holding a wafer 200 on its top side, and claws 102 (only one can be seen in fig. 4) for clamping the wafer 200 against the plate 101. The claw 102 is an essentially C-shaped part that consists of a base portion 103 and two fingers 104 and 105. The fingers 104 and 105 are arranged parallel to the plate 101. The claw 102 is arranged in connection with the plate 101 so that the wafer 200 can be clamped between the finger 104 and the plate 101. The finger 105 is facing a bottom side of the plate 101.

A pivot arm 110 that is rotatable about a pivot point 111 is arranged in connection with the claw 102 in such a manner that its first end is located between the finger 105 and the plate 101. A piezoelectric actuator 106 is attached to a second end of the pivot arm 110 with a rod 109, and it is used for rotating the pivot arm 110 about the pivot point 111. When the pivot arm 110 is rotated about the pivot point 111 in a first direction of rotation, the first end of the pivot arm 110 pushes the finger 105 away from the plate 101, whereby the finger 104 moves towards the plate 101, and as a result the wafer 200 that is placed on the plate 101 is clamped between the plate 101 and the finger 104. When the pivot arm 110 is rotated about the pivot point 111 in a second direction of rotation, the wafer 200 can be released.

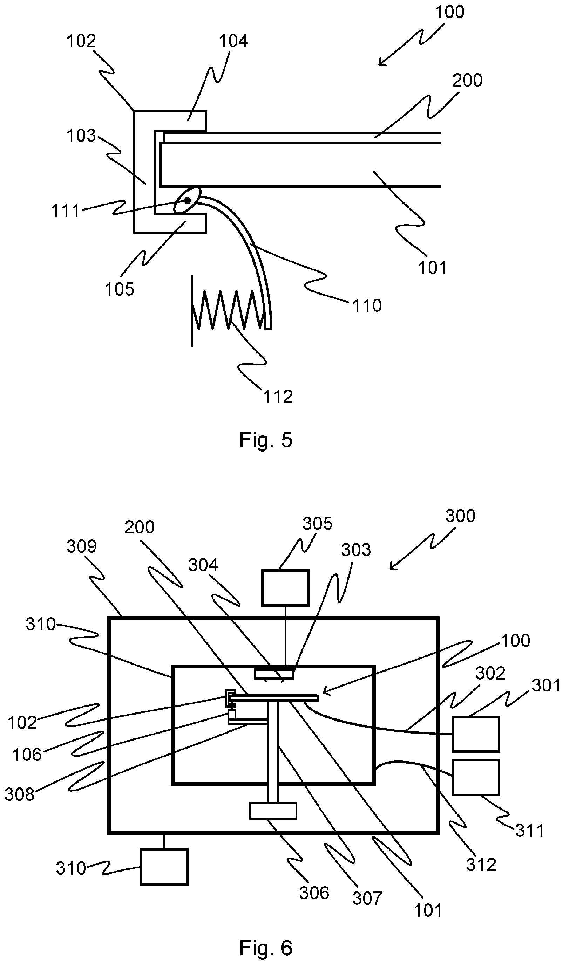

Fig. 5 illustrates a cross-sectional view of a wafer chuck according to a fourth embodiment of the invention. The wafer chuck 100 comprises a plate 101 for holding a wafer 200 on its top side, and claws 102 (only one can be seen in fig. 5) for clamping the wafer 200 against the plate 101. The claw 102 is an essentially C-shaped part that consists of a base portion 103 and two fingers 104 and 105. The fingers 104 and 105 are arranged parallel to the plate 101. The claw 102 is arranged in connection with the plate 101 so that the wafer 200 can be clamped between the finger 104 and the plate 101. The finger 105 is facing a bottom side of the plate 101.

A pivot arm 110 that is rotatable about a pivot point 111 is arranged in connection with the claw 102 in such a manner that its first end is located between the finger 105 and the plate 101. When the pivot arm 110 is rotated about the pivot point 111 in a first direction of rotation, the first end of the pivot arm 110 pushes the finger 105 away from the plate 101, whereby the finger 104 moves towards the plate 101, and as a result the wafer 200 that is placed on the plate 101 is clamped between the plate 101 and the finger 104. When the pivot arm 110 is rotated about the pivot point 111 in a second direction of rotation, the wafer 200 can be released.

In the wafer chuck of fig. 5, a spring 112 is attached to the second end of the pivot arm 110. The spring 112 is arranged to produce a force that keeps the wafer 200 clamped between the plate 101 and the finger 104. In order to release the wafer 200, a counterforce is needed to rotate the pivot arm 110 about the pivot point 111 in the second direction of rotation. Such counterforce can be produced, for example, by a wafer loading device.

Fig. 6 illustrates a cross-sectional view of a wafer prober according to an embodiment of the invention. The wafer prober 300 is used for electrically testing integrated circuits (not shown in fig. 6) on a wafer 200.

The wafer prober 300 comprises a wafer chuck 100 for holding the wafer 200 during testing. The wafer chuck 100 is similar to the wafer chuck of fig. 1, wherein the wafer 200 can be clamped against the plate 101 by using the claws 102. The wafer prober 300 comprises a cooling unit 301 that is thermally connected to the plate 101 with a cable 302. As the plate 101 is cooled, heat from the wafer 200 transfers to the plate 101 by conduction. Because the wafer chuck 100 provides a very good thermal contact between the wafer 200 and the plate 101, the cooling unit 301 enables to efficiently cool the wafer 200 through the plate 101 of the wafer chuck 100.

The wafer prober 300 comprises a probe card 303 for electrically contacting the integrated circuits on the wafer 200. The probe card 303 comprises contact elements 304, which can be arranged in electrical contact with contact pads (not shown in fig. 6) of the integrated circuits. The probe card 303 is electrically connected to an electronic testing unit 305 that can electrically test the integrated circuits according to a test program. For electrical testing, the probe card 303 is held in place while the wafer 200 mounted on the plate 101 is moved between testing positions by using an actuator 306 that is connected to the plate 101 with a supporting column 307. The piezoelectric actuator 106 is attached to the supporting column 307 with a rod 308. In each testing position, contact elements 304 of the probe card 303 are arranged in electrical contact with contact pads of a set of integrated circuits, which are then electrically tested with the electronic testing unit 305.

The wafer prober 300 comprises a vacuum chamber 309 to which is connected a vacuum pump 310 that allows the pressure inside the vacuum chamber 309 to be controlled. Inside the vacuum chamber 309 there is a radiation shield 310 that encloses the wafer chuck 100 and the probe card 303. The radiation shield 310 is thermally connected to a cooling unit 311 with a cable 312. The cooling unit 311 is used for cooling the interior of the radiation shield 310 to a desired testing temperature and for maintaining the testing temperature during testing of the integrated circuits.

Only advantageous exemplary embodiments of the invention are described in the figures. It is clear to a person skilled in the art that the invention is not restricted only to the examples presented above, but the invention may vary within the limits of the claims presented hereafter. Some possible embodiments of the invention are described in the dependent claims, and they are not to be considered to restrict the scope of protection of the invention as such.

## Claims

1. A wafer chuck, comprising:
- a plate for holding a wafer, and
- clamping means for clamping the wafer against the plate,
**characterised in that** the clamping means comprises:
- a plurality of claws having first fingers, each claw being arranged in connection with the plate so that the wafer can be clamped between the plate and the first finger of the claw, and
- moving means for moving the plurality of claws with respect to the plate.

2. The wafer chuck according to claim 1, **characterised in that** the plurality of claws have second fingers.

3. The wafer chuck according to claim 1 or 2, **characterised in that** the moving means comprises a plurality of actuators, each actuator being attached to one of the plurality of claws.

4. The wafer chuck according to claim 2, **characterised in that** the moving means comprises:
- a plurality of threaded elements having first and second ends, each threaded element being arranged to go through the second finger of one of the plurality of claws, and
- a plurality of actuators for rotating the plurality of threaded elements, each actuator being attached to the first end of one of the plurality of threaded elements.

5. The wafer chuck according to claim 2, **characterised in that** the moving means comprises a plurality of pivot arms having first and second ends, each pivot arm being rotatable about a pivot point and arranged so that the first end of the pivot arm is located between the plate and the second finger of one of the plurality of claws.

6. The wafer chuck according to claim 5, **characterised in that** the moving means comprises a plurality of actuators for rotating the plurality of pivot arms about the pivot points, each actuator being attached to the second end of one of the plurality of pivot arms.

7. The wafer chuck according to claim 5, **characterised in that** the moving means comprises a plurality of springs, each spring being attached to the second end of one of the plurality of pivot arms.

8. The wafer chuck according to claim 3, 4 or 6, **characterised in that** the plurality of actuators are piezoelectric actuators.

9. The wafer chuck according to any of the preceding claims, **characterised in that** the total clamping force of the clamping means is 200-1200 N.

10. The wafer chuck according to any of the preceding claims, **characterised in that** the plurality of claws are evenly distributed around the perimeter of the plate.

11. The wafer chuck according to any of the preceding claims, **characterised in that** the number of claws is 3-6.

12. A wafer prober, **characterised in that** the wafer prober comprises a wafer chuck according to any of the preceding claims and a cooling unit thermally connected to a plate of the wafer chuck.

13. The wafer prober according to claim 12, **characterised in that** the cooling unit is a dry cryostat using a closed loop helium circulation.

14. A method for cooling a wafer, **characterised in that** the method comprises:
- placing the wafer on a plate of a wafer chuck according to any of claims 1 to 11,
- cooling the plate,
- determining the temperature of the plate, and
- after the temperature of the plate has dropped below a predetermined temperature value, clamping the wafer against the plate with a plurality of claws of the wafer chuck.

15. The method according to claim 14, **characterised in that** the predetermined temperature value is in the range of 40-60 K.
